# EUROPEAN PATENT APPLICATION

(11) **EP 4 661 056 A1**
(43) Date of publication of application: **10.12.2025**
(21) Application number: 23919882.3
(22) Date of filing: 10.11.2023
(51) Int. Cl.: H01L 21/304

(54) **SUBSTRATE PROCESSING APPARATUS AND SUBSTRATE PROCESSING METHOD**

(30) Priority: 31.01.2023 JP 2023012482
(71) Applicant: SCREEN Holdings Co., Ltd., Kyoto-shi, Kyoto 602-8585 (JP)
(72) Inventor: IWAO, Michinori, Kyoto-shi, Kyoto 602-8585 (JP); KAMON, Hiroaki, Kyoto-shi, Kyoto 602-8585 (JP); IWAHATA, Shota, Kyoto-shi, Kyoto 602-8585 (JP)
(74) Representative: Kilian Kilian & Partner mbB
(86) International application number: PCT/JP2023/040531
(87) International publication number: WO 2024/161747

(57) **Abstract**

Various processes on substrates are efficiently performed. A substrate processing apparatus includes: a first valve disposed in a first pipe for supplying a supply tank with a first processing liquid; a second valve disposed in a second pipe to allow a generator to recover the first processing liquid from a substrate processing part; a third valve disposed in a third pipe for supplying the supply tank with a second processing liquid from a supply source; and a fourth valve disposed in a fourth pipe for circulating the second processing liquid through the supply tank, wherein in the first mode, the first valve and the second valve are opened, and the third valve and the fourth valve are closed, and in the second mode, the third valve and the fourth valve are opened, and the first valve and the second valve are closed.

## Description

### TECHNICAL FIELD

The technology disclosed in this DESCRIPTION relates to a substrate processing technology. Examples of a substrate to be processed include a semiconductor wafer, a liquid crystal display glass substrate, a substrate for a flat panel display (FPD) such as an organic electroluminescence (EL) display, an optical disk substrate, a magnetic disk substrate, a magneto-optical disk substrate, a photolithographic mask glass substrate, a ceramic substrate, a field emission display (i.e., FED) substrate, and a solar cell substrate.

### BACKGROUND ART

What has conventionally been disclosed is a technology using electrolyzed sulfuric acid as a processing liquid for processing substrates, instead of using, for example, SPM that has a large amount of drainage as a processing liquid (see, for example, Patent Document 1).

### PRIOR ART DOCUMENT

### PATENT DOCUMENT

Patent Document 1: Japanese Patent No. 5751426

### SUMMARY

### PROBLEM TO BE SOLVED BY THE INVENTION

When electrolyzed sulfuric acid is used as a processing liquid for various processes on substrates, some of the processes are not appropriate in view of, for example, the oxidizing strength or the etching rate. When electrolyzed sulfuric acid is used for such processes, the efficiency for processing substrates may decrease.

The technology disclosed in this DESCRIPTION has been conceived in view of the aforementioned problem, and is a technology for efficiently performing various processes on substrates.

### MEANS TO SOLVE THE PROBLEM

A substrate processing apparatus that is a first aspect of the technology disclosed in the DESCRIPTION includes: a substrate processing part for processing a substrate using a first processing liquid containing electrolyzed sulfuric acid or a second processing liquid containing sulfuric acid; a supply tank for supplying the first or second processing liquid to the substrate processing part; a generator that generates the first processing liquid through electrolysis such that the generated first processing liquid can be supplied to the supply tank; a recovering part that recovers the first processing liquid supplied to the substrate processing part to supply the first processing liquid to the generator; a supply source that can supply the second processing liquid to the supply tank; a circulation part for circulating, through the supply tank, the second processing liquid supplied to the substrate processing part; and a valve mechanism that is switchable between a first mode and a second mode, the first mode being a mode in which the substrate processing part processes the substrate using the first processing liquid, the second mode being a mode in which the substrate processing part processes the substrate using the second processing liquid, the valve mechanism including: a first valve disposed in a first pipe for supplying the supply tank with the first processing liquid generated by the generator; a second valve disposed in a second pipe to allow the generator to recover, from the substrate processing part, the first processing liquid supplied to the substrate processing part; a third valve disposed in a third pipe for supplying the supply tank with the second processing liquid from the supply source; and a fourth valve disposed in a fourth pipe for circulating the second processing liquid through the supply tank, wherein in the first mode, the first valve and the second valve are opened, and the third valve and the fourth valve are closed, and in the second mode, the third valve and the fourth valve are opened, and the first valve and the second valve are closed.

The substrate processing apparatus that is a second aspect of the technology disclosed in the DESCRIPTION is relevant to the substrate processing apparatus according to the first aspect, and the substrate processing part further includes a mixing part for mixing given water with the first or second processing liquid supplied from the supply tank.

The substrate processing apparatus that is a third aspect of the technology disclosed in the DESCRIPTION is relevant to the substrate processing apparatus according to the first or second aspect, and further includes a heater in the first pipe for increasing a temperature of the first processing liquid to a temperature for processing the substrate.

A substrate processing method that is a fourth aspect of the technology disclosed in the DESCRIPTION is a substrate processing method for processing a substrate using a substrate processing apparatus, and the substrate processing apparatus includes: a substrate processing part for processing the substrate using a first processing liquid containing electrolyzed sulfuric acid or a second processing liquid containing sulfuric acid; a supply tank for supplying the first or second processing liquid to the substrate processing part; a generator that generates the first processing liquid through electrolysis such that the generated first processing liquid can be supplied to the supply tank; a recovering part that recovers the first processing liquid supplied to the substrate processing part to supply the first processing liquid to the generator; a supply source that can supply the second processing liquid to the supply tank; and a circulation part for circulating, through the supply tank, the second processing liquid supplied to the substrate processing part, the method includes: a first step of supplying the substrate processing part with the first processing liquid for processing the substrate; and a second step of supplying the substrate processing part with the second processing liquid for processing the substrate, wherein the first step includes supplying the supply tank with the first processing liquid generated by the generator, and allowing the generator to recover, through the recovering part, the first processing liquid supplied from the supply tank to the substrate processing part, and the second step includes supplying the second processing liquid from the supply source to the supply tank, and circulating, in the supply tank through the circulation part, the second processing liquid supplied from the supply tank to the substrate processing part.

### EFFECTS OF THE INVENTION

According to at least the first and fourth aspects of the technology disclosed in the DESCRIPTION, switchably using electrolyzed sulfuric acid and sulfuric acid for processing a substrate can select an appropriate processing liquid for various processes on substrates and efficiently process the substrates.

The object, features, aspects, and advantages relevant to the technology disclosed in the DESCRIPTION will become more apparent from the following detailed description and the accompanying drawings.

### BRIEF DESCRIPTION OF DRAWINGS

[FIG. 1] is a diagram illustrating an example structure of a substrate processing apparatus according to an embodiment.
[FIG. 2] conceptually illustrates one example configuration of a controller exemplified in FIG. 1.
[FIG. 3] is a diagram schematically illustrating an example structure of a processing unit and its relevant structure in the substrate processing apparatus according to this embodiment.
[FIG. 4] is a cross-sectional view illustrating an internal structure of a discharge nozzle.
[FIG. 5] is a diagram illustrating an example structure of the substrate processing apparatus in a circulating state of discharge nozzles when electrolyzed sulfuric acid is supplied from the supply tank.
[FIG. 6] is a diagram illustrating an example structure of the substrate processing apparatus in a discharging state of the discharge nozzles when electrolyzed sulfuric acid is supplied from the supply tank.
[FIG. 7] is a diagram illustrating an example structure of the substrate processing apparatus in the circulating state of the discharge nozzles when sulfuric acid is supplied from the supply tank.
[FIG. 8] is a diagram illustrating an example structure of the substrate processing apparatus in the discharging state of the discharge nozzles when sulfuric acid is supplied from the supply tank.
[FIG. 9] is a flowchart when the substrate processing apparatus according to the embodiment continuously performs a plurality of processes on substrates.

### DESCRIPTION OF EMBODIMENTS

An embodiment will be described below with reference to the attached drawings. Although the embodiment below will describe detailed features for description of a technology, the features are mere exemplification and are not necessarily essential features for making the embodiment feasible.

The drawings are drawn in schematic form, and structures are appropriately omitted or simplified in the drawings for convenience in description. The mutual relationships in size and position between the structures in different drawings are not necessarily accurate but may be changed when needed. The drawings such as plan views except cross-sectional views are sometimes hatched for facilitating the understanding of the details of the embodiment.

In the following description, the same reference numerals are assigned to the same constituent elements, and their names and functions are the same. Therefore, detailed description of such constituent elements may be omitted to avoid redundant description.

Unless otherwise specified, an expression "comprising", "including", or "having" a certain constituent element is not an exclusive expression for excluding the presence of the other constituent elements in this DESCRIPTION.

Even when ordinal numbers such as "first" and "second" are used in this DESCRIPTION, these terms are used for convenience to facilitate the understanding of the details of the embodiment. The order indicated by these ordinal numbers does not restrict the details of the embodiment.

In this DESCRIPTION, when terms meaning a particular position and a particular direction such as "up", "down", "left", "right", "side", "bottom", "front", or "back" are used, these are used for convenience to facilitate the understanding of the details of the embodiment, and need not always coincide with a position and a direction when the embodiment is actually implemented.

In this DESCRIPTION, an expression of, for example, "an upper surface of" or "a lower surface of" a target constituent element includes states where not only the upper surface or the lower surface of the element itself is formed but also another constituent element is formed on the upper surface or the lower surface of the element. In other words, for example, an expression "B formed on an upper surface of A" does not prevent interposition of another element "C" between A and B.

### <Embodiment>

A substrate processing apparatus and a substrate processing method according to this embodiment will be hereinafter described.

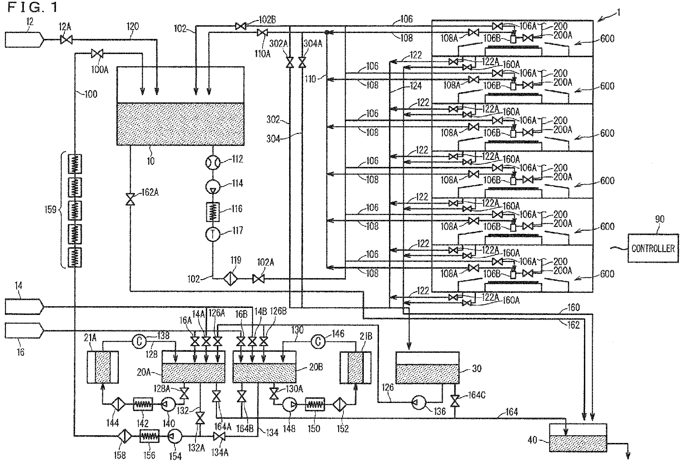

FIG. 1 is a diagram illustrating an example structure of a substrate processing apparatus according to this embodiment. As exemplified in FIG. 1, a substrate processing apparatus 1 includes a plurality of processing units 600, a supply tank 10, production tanks 20A and 20B, electrolytic cells 21A and 21B, a recovering tank 30, a waste tank 40 that drains, for example, a processing liquid, and a controller 90. Here, the processing liquid is a liquid containing electrolyzed sulfuric acid or a liquid containing sulfuric acid. Hereinafter, the liquid containing electrolyzed sulfuric acid may be simply referred to as "electrolyzed sulfuric acid". Similarly, a processing liquid containing sulfuric acid may be simply referred to as "sulfuric acid". Electrolyzed sulfuric acid indicates persulfuric acid (peroxodisulfuric acid, i.e., H₂S₂O₈) to be generated by electrolyzing sulfuric acid. Persulfuric acid has a higher oxidizing strength than that of Caro's acid (H₂SO₅) at the same temperature.

The processing units 600 process substrates using electrolyzed sulfuric acid or sulfuric acid that is supplied. A detailed structure of each of the processing units 600 will be described later. The number of the processing units 600 is not limited to the number in FIG. 1.

The supply tank 10 stores the electrolyzed sulfuric acid supplied from the production tank 20A or the production tank 20B through a supply pipe 100. Then, the supply tank 10 supplies the electrolyzed sulfuric acid to the processing units 600. Furthermore, the supply tank 10 stores the sulfuric acid supplied from a sulfuric acid supply source 12 through a supply pipe 120. Then, the supply tank 10 supplies the sulfuric acid to the processing units 600. A flow rate of the sulfuric acid supplied from the sulfuric acid supply source 12 through the supply pipe 120 can be adjusted by the controller 90 through control of a valve 12A.

In other words, the supply tank 10 can selectively store and supply electrolyzed sulfuric acid and sulfuric acid.

Pipes for supplying electrolyzed sulfuric acid or sulfuric acid from the supply tank 10 include: a circulation pipe 102 that is connected to the supply tank 10 and circulates sulfuric acid through the supply tank 10; a recovering pipe 302 which branches from the circulation pipe 102 and through which electrolyzed sulfuric acid is recovered by the recovering tank 30; supply pipes 106 that branch from the circulation pipe 102 upstream of the recovering pipe 302 to supply electrolyzed sulfuric acid or sulfuric acid to the respective processing units 600; return pipes 108 that branch from downstream ends of the supply pipes 106 to return electrolyzed sulfuric acid or sulfuric acid to the supply tank 10; a circulation pipe 110 that returns the sulfuric acid that merges from the return pipes 108 to the supply tank 10; and a recovering pipe 304 which branches from the circulation pipe 110 and through which electrolyzed sulfuric acid is recovered by the recovering tank 30.

In the circulation pipe 102, a flowmeter 112 that measures a flow rate of electrolyzed sulfuric acid or sulfuric acid, a pump 114 that allows electrolyzed sulfuric acid or sulfuric acid to flow, a heater 116 that heats electrolyzed sulfuric acid or sulfuric acid, and a thermometer 117 that measures a temperature of electrolyzed sulfuric acid or sulfuric acid are disposed.

Furthermore, a filter 119 for removing, for example, particles in electrolyzed sulfuric acid or sulfuric acid, a valve 102A that can adjust a flow rate of electrolyzed sulfuric acid or sulfuric acid flowing through the circulation pipe 102 under control of the controller 90, and a valve 102B that is closed when electrolyzed sulfuric acid flows through the recovering pipe 302 are disposed in the circulation pipe 102.

A valve 302A that can adjust a flow rate of the electrolyzed sulfuric acid supplied to the recovering tank 30 under control of the controller 90 is disposed in the recovering pipe 302.

In each of the supply pipes 106, a valve106A that can adjust a flow rate of electrolyzed sulfuric acid or sulfuric acid flowing through the supply pipe 106 under control of the controller 90 is disposed. A part of the electrolyzed sulfuric acid or the sulfuric acid flowing through the circulation pipe 102 at a flow rate flows through the supply pipe 106.

In each of the return pipes 108, a valve108A that can adjust a flow rate of electrolyzed sulfuric acid or sulfuric acid flowing through the return pipe 108 under control of the controller 90 is disposed.

In the circulation pipe 110, a valve 110A that is closed when electrolyzed sulfuric acid flows through the recovering pipe 304 is disposed.

In the recovering pipe 304, a valve 304A that can adjust a flow rate of the electrolyzed sulfuric acid supplied to the recovering tank 30 under control of the controller 90 is disposed.

Furthermore, a portion at which the return pipe 108 branches from the supply pipe 106 is disposed in a discharge nozzle 106B in each of the processing units 600. The discharge nozzle 106B is further connected to a mixing pipe 200 that mixes given water that is pure water (DIW), aqueous hydrogen peroxide, or ozonized water with the electrolyzed sulfuric acid or the sulfuric acid in the supply pipe 106. In the mixing pipe 200, a valve 200A that can adjust a flow rate of the given water flowing through the mixing pipe 200 under control of the controller 90 is disposed.

The given water to be supplied to the mixing pipe 200 may be supplied from a pure water supply source 14 or from a supply source separately prepared.

Pipes that recover electrolyzed sulfuric acid from the processing units 600 include: drainage pipes 122 connected to the respective processing units 600 to drain electrolyzed sulfuric acid (a processed solution) used for processing substrates; a recovering pipe 124 that supplies the recovering tank 30 with the processed solution that merges from the drainage pipes 122; a recovering pipe 126 connected to the recovering tank 30 to supply the processed solution to the production tank 20A or the production tank 20B; a circulation pipe 128 that circulates electrolyzed sulfuric acid between the production tank 20A and the electrolytic cell 21A; a circulation pipe 130 that circulates electrolyzed sulfuric acid between the production tank 20B and the electrolytic cell 21B; a supply pipe 132 that merges the electrolyzed sulfuric acid from the production tank 20A into the supply pipe 100; and a supply pipe 134 that merges the electrolyzed sulfuric acid from the production tank 20B into the supply pipe 100. In each of the drainage pipes 122, a valve 122A that adjusts a flow rate of drainage from the processing unit 600 under control of the controller 90 is disposed.

Here, a plurality of the recovering tanks 30 may be disposed in parallel. In other words, the processed solution from the recovering pipe 124 may be selectively supplied to the plurality of recovering tanks, and the time for supplying the processed solution from the recovering tanks to the production tanks may be increased.

In the recovering pipe 126, a pump 136 that feeds the processed solution stored in the recovering tank 30 to the production tank 20A or the production tank 20B, a valve 126A that can adjust a flow rate of the processed solution to be fed to the production tank 20A under control of the controller 90, and a valve 126B that can adjust a flow rate of the processed solution to be fed to the production tank 20B under control of the controller 90 are disposed.

In the circulation pipe 128, a valve 128A for adjusting a flow rate of the electrolyzed sulfuric acid flowing through the circulation pipe 128, a concentration meter 138 that measures a concentration of the electrolyzed sulfuric acid flowing through the circulation pipe 128, a pump 140 that feeds the electrolyzed sulfuric acid flowing through the circulation pipe 128, a heater 142 that heats the electrolyzed sulfuric acid, and a filter 144 that removes, for example, particles in the electrolyzed sulfuric acid are disposed.

In the circulation pipe 130, a valve 130A for adjusting a flow rate of the electrolyzed sulfuric acid flowing through the circulation pipe 130, a concentration meter 146 that measures a concentration of the electrolyzed sulfuric acid flowing through the circulation pipe 130, a pump 148 that feeds the electrolyzed sulfuric acid flowing through the circulation pipe 130, a heater 150 that heats the electrolyzed sulfuric acid, and a filter 152 that removes, for example, particles in the electrolyzed sulfuric acid are disposed.

In the supply pipe 132, a valve132A that can adjust a flow rate of the electrolyzed sulfuric acid flowing through the supply pipe 132 under control of the controller 90 is disposed.

In the supply pipe 134, a valve134A that can adjust a flow rate of the electrolyzed sulfuric acid flowing through the supply pipe 134 under control of the controller 90 is disposed.

In the supply pipe 100, a pump 154 that feeds the electrolyzed sulfuric acid flowing through the supply pipe 100, a heater 156 and heaters 159 that heat the electrolyzed sulfuric acid, a filter 158 that removes, for example, particles in the electrolyzed sulfuric acid, and a valve 100A for adjusting a flow rate of the electrolyzed sulfuric acid flowing through the supply pipe 100 are disposed.

The electrolyzed sulfuric acid supplied from the production tanks to the supply tank 10 is heated by the heater 156 and the heaters 159 disposed in the supply pipe 100 and by the heater 116 disposed in the circulation pipe 102 to raise the temperature of the electrolyzed sulfuric acid, and is then supplied to the processing units 600.

Furthermore, the pure water supply source 14 supplies pure water (DIW), aqueous hydrogen peroxide, or ozonized water to the production tanks 20A and 20B. A flow rate of, for example, the pure water supplied from the pure water supply source 14 to the production tank 20A can be adjusted by the controller 90 through control of a valve 14A. Furthermore, a flow rate of, for example, the pure water supplied from the pure water supply source 14 to the production tank 20B can be adjusted by the controller 90 through control of a valve 14B. The pure water supply source 14 need not be included.

A sulfuric acid supply source 16 supplies sulfuric acid (H₂SO₄) to the production tanks 20A and 20B. A flow rate of the sulfuric acid supplied from the sulfuric acid supply source 16 to the production tank 20A can be adjusted by the controller 90 through control of a valve 16A. Furthermore, a flow rate of the sulfuric acid supplied from the sulfuric acid supply source 16 to the production tank 20B can be adjusted by the controller 90 through control of a valve 16B. The sulfuric acid supply source 16 need not be included.

Pipes that drain electrolyzed sulfuric acid, a processed solution, or sulfuric acid include: drainage pipes 160 that drain the processed solution from the processing units 600 to the waste tank 40; a drainage pipe 162 that drains the electrolyzed sulfuric acid or the sulfuric acid from the supply tank 10 to the waste tank 40; and a drainage pipe 164 that drains the electrolyzed sulfuric acid or the processed solution from the production tanks 20A and 20B and the recovering tank 30 to the waste tank 40. In each of the drainage pipes 160, a valve 160A that adjusts a flow rate of drainage from the processing units 600 under control of the controller 90 is disposed. In the drainage pipe 162, a valve 162A that adjusts a flow rate of drainage from the supply tank 10 under control of the controller 90 is disposed. In the drainage pipe 164, a valve 164A that adjusts a flow rate of drainage from the production tank 20A under control of the controller 90, a valve 164B that adjusts a flow rate of drainage from the production tank 20B under control of the controller 90, and a valve 164C that adjusts a flow rate of drainage from the recovering tank 30 under control of the controller 90 are disposed.

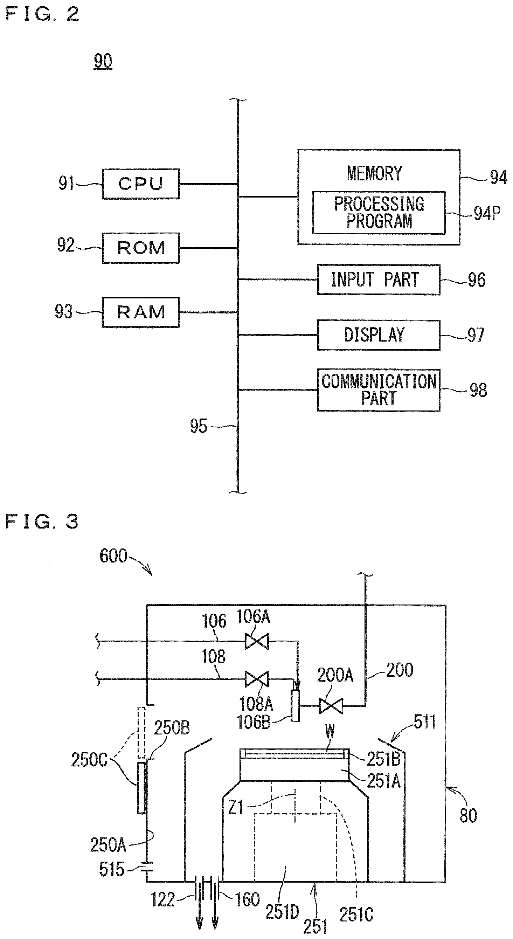

FIG. 2 conceptually illustrates one example configuration of the controller 90 exemplified in FIG. 1. The controller 90 may be implemented by a common computer with an electrical circuit. Specifically, the controller 90 includes a central processing unit (i.e., CPU) 91, a read-only memory (i.e., ROM) 92, a random-access memory (i.e., RAM) 93, a memory 94, an input part 96, a display 97, a communication part 98, and a bus line 95 that mutually connects these.

The ROM 92 stores a basic program. The RAM 93 is used as a work area for the CPU 91 to perform a predetermined process. The memory 94 includes a non-volatile storage device such as a flash memory or a hard disk device. The input part 96 includes various switches or a touch panel to receive, from an operator, an input setting instruction such as a processing recipe. The display 97 includes, for example, a liquid crystal display and a lamp to display various information under control of the CPU 91. The communication part 98 has a data communication function through, for example, a local area network (LAN).

A plurality of modes on the control over the structures in the substrate processing apparatus 1 in FIG. 1 are preset in the memory 94. The CPU 91 executes a processing program 94P, so that one of the plurality of modes is selected to control each of the structures. The processing program 94P may be stored in a recording medium. The processing program 94P can be installed in the controller 90 using this recording medium. Furthermore, a part or the entirety of functions to be executed by the controller 90 need not always be implemented by software, but may be implemented by hardware such as a dedicated logic circuit.

FIG. 3 is a diagram schematically illustrating an example structure of the processing unit 600 and its relevant structure in the substrate processing apparatus according to this embodiment. While FIG. 3 exemplifies the structure of the processing unit 600 disposed downstream of one of the supply pipes 106 in FIG. 1, each of the structures of the processing units 600 disposed downstream of the other supply pipes 106 is the same structure exemplified in FIG. 3.

As exemplified in FIG. 3, the processing unit 600 includes a box-shaped chamber 80 with an internal space, a spin chuck 251 that rotates one substrate W about a vertical rotation axis line Z1 that passes through a center of the substrate W while holding the substrate W in a horizontal attitude in the chamber 80, and a tubular processing cup 511 that surrounds the spin chuck 251 about the rotation axis line Z1 of the substrate W.

The chamber 80 is surrounded by a box-shaped wall 250A. An opening 250B is formed in the wall 250A to transport the substrate W in and out of the chamber 80.

The opening 250B is opened and closed by a shutter 250C. A shutter elevating mechanism (not illustrated herein) moves the shutter 250C up and down between a closed position (indicated by a double dot-dashed line in FIG. 3) at which the opening 250B is covered with the shutter 250C and an open position (indicated by a solid line in FIG. 3) at which the opening 250B is opened.

As exemplified in FIG. 3, the spin chuck 251 includes a disc-shaped spin base 251A disposed to face the substrate W in the horizontal attitude, a plurality of chuck pins 251B protruding from an outer periphery of a top of the spin base 251A and clamping a peripheral portion of the substrate W, a rotating shaft 251C that extends downward from the center of the spin base 251A, and a spin motor 251D that rotates the substrate W that is chucked to the spin base 251A by rotating the rotating shaft 251C.

The spin chuck 251 is not limited to a clamping-type chuck exemplified in FIG. 3 but may be, for example, a vacuum-suction type chuck including a spin base that vacuum suctions the lower surface of the substrate W.

Nozzles for discharging liquids for other applications (e.g., a nozzle that discharges another chemical solution or a nozzle that discharges a rinse liquid) may be connected to the processing units 600.

Furthermore, the discharge nozzle 106B that discharges electrolyzed sulfuric acid or sulfuric acid is connected to the end of the supply pipe 106 connected to the processing unit 600 as exemplified in FIG. 3. The discharge nozzle 106B discharges electrolyzed sulfuric acid or sulfuric acid toward a predetermined portion inside the chamber 80 (e.g., the spin base 251A).

The processing cup 511 is disposed to surround the spin chuck 251, and is moved up and down in the vertical direction by an elevating mechanism (e.g., a motor or a cylinder) that is not illustrated. An upper portion of the processing cup 511 is moved up and down between an up position at which its upper end is higher than the substrate W held by the spin base 251A and a down position at which the upper end is lower than the substrate W.

Electrolyzed sulfuric acid or sulfuric acid that flies off from the upper surface of the substrate W is received by an inner side surface of the processing cup 511. Then, the electrolyzed sulfuric acid or the sulfuric acid received by the processing cup 511 is appropriately drained outside of the chamber 80 through the drainage pipes 122 and 160 disposed at the bottom of the chamber 80 and inside the processing cup 511. Furthermore, a cup exhaust mechanism that is not illustrated discharges an atmosphere inside the processing cup 511.

Furthermore, an exhaust outlet 515 is disposed along a side of the chamber 80. The atmosphere inside the chamber 80 is discharged outside the chamber 80 through this exhaust outlet 515.

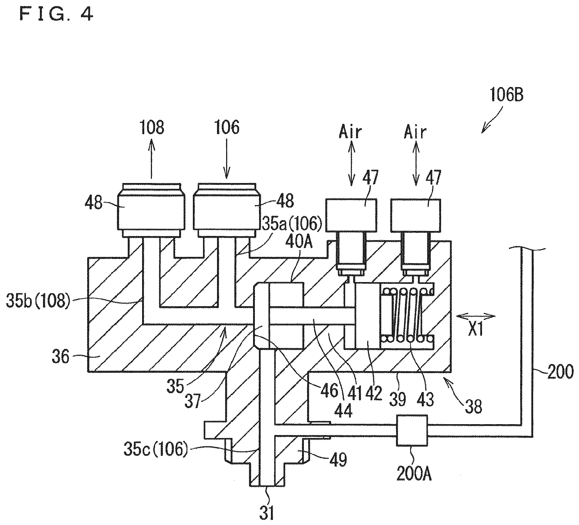

FIG. 4 is a cross-sectional view illustrating an internal structure of the discharge nozzle 106B.

The discharge nozzle 106B includes a body 36 in which a channel 35 that leads electrolyzed sulfuric acid or sulfuric acid is formed, a valve body 37 that opens and closes the channel 35, a pneumatic actuator 38 that opens and closes the channel 35 by advancing or retracting the valve body 37 in an axial direction X1, the mixing pipe 200 that merges into a position (a channel 35c) more downstream than the valve body 37 in the channel 35, and an outlet 31.

The body 36 includes: a cylinder 39 included in the pneumatic actuator 38; a valve chamber 40A that advances or retracts the valve body 37; a channel 35a that reaches the valve chamber 40A in communication with the supply pipe 106 through a joint 48; a channel 35b that is connected to the channel 35a at a position upstream of the valve 40A with respect to the channel 35a and communicates with the return pipe 108 through a joint 48; and a channel 35c that reaches the outlet 31 from the valve chamber 40A.

The cylinder 39 and the valve chamber 40A are aligned in the axial direction X1. The cylinder 39 and the valve chamber 40A are separated by a barrier 41. The channel 35a and the channel 35c are a part of the supply pipe 106 that guides, to the outlet 31, electrolyzed sulfuric acid or sulfuric acid supplied from the supply tank 10. Furthermore, the channel 35b is a part of the return pipe 108 that returns electrolyzed sulfuric acid or sulfuric acid to the supply tank 10.

The pneumatic actuator 38 includes the cylinder 39, a piston 42, a spring 43, and a rod 44. The cylinder 39 is separated by the piston 42 from a front chamber closer to the barrier 41 and a rear chamber on the opposite side across the piston 42 in the axial direction X1. Joints 47 for connecting tubes that transfer air pressure to the front chamber and the rear chamber of the cylinder 39 are connected to the body 36. The piston 42 is advanced or retracted in the cylinder 39 in the axial direction X1 by transferring air pressure to the front chamber or the rear chamber of the cylinder 39 through the tubes or the joints 47.

The spring 43 is inserted closer to the rear chamber of the cylinder 39 between the piston 42 and the body 36 to pressurize the piston 42 to a direction of the barrier 41.

A base of the rod 44 is coupled to the piston 42, and the end of the rod 44 penetrates the barrier 41 to protrude into the valve chamber 40A. The valve body 37 is coupled to the end of the rod 44 protruding into the valve chamber 40A. The valve body 37 is disc-shaped, and is coupled to the end of the rod 44 with a radial direction being orthogonal to the axial direction X1. When the piston 42 is advanced or retracted in the cylinder 39 in the axial direction X1, the valve body 37 is advanced or retracted along the axial direction X1 in the valve chamber 40A through the rod 44.

The valve chamber 40A faces the barrier 41, and includes an annular seating surface 46 orthogonal to the axial direction X1. The channel 35a is concentrically opened at a center position of the seating surface 46. The channel 35c is opened at a lateral side of the valve chamber 40A in the advancing/retracting direction (the axial direction X1) of the valve body 37.

The body 36 includes a tube 49 at the end of which the outlet 31 is formed and which protrudes downward from the lower surface of a nozzle head 26. Furthermore, the mixing pipe 200 is inserted into a lateral side of the tube 49, and is connected to the channel 35c at a position downstream of the valve chamber 40A.

While air pressure does not act on the front chamber or the rear chamber of the cylinder 39 and the pneumatic actuator 38 is not operated, the piston 42 is pressurized by the spring 43 in an advancing position in the cylinder 39, that is, in a position closer to the barrier 41 as exemplified in FIG. 4. Thereby, the valve body 37 comes in contact with the seating surface 46 in the valve chamber 40A to close the opening of the channel 35a.

Thus, while a portion between the channels 35a and 35c is closed, electrolyzed sulfuric acid or sulfuric acid supplied from the supply tank 10 through the supply pipe 106 and the channel 35a is returned to the supply tank 10 through the channel 35b and the return pipe 108 (a circulating state).

In this circulating state, when air pressure is transferred to the front chamber of the cylinder 39 and the piston 42 is retracted to the rear chamber direction of the cylinder 39 against the pressing force of the spring 43, the valve body 37 is separated from the seating surface 46 in the valve chamber 40A, and the opening of the channel 35a is released to the valve chamber 40A. Thus, the channel 35a is connected to the channel 35c through the valve chamber 40A, and electrolyzed sulfuric acid or sulfuric acid supplied from the supply tank 10 through the supply pipe 106 and the channel 35a is discharged from the outlet 31 through the channel 35c (a discharging state).

In this discharging state, when transfer of air pressure to the front chamber of the cylinder 39 is stopped, and instead, air pressure is transferred to the rear chamber of the cylinder 39 to advance, together with the pressing force of the spring 43, the piston 42 to a front chamber direction of the cylinder 39, that is, a direction approximating the barrier 41, the valve body 37 comes in contact with the seating surface 46 in the valve chamber 40A to close the opening of the channel 35a. Thus, while the portion between the channels 35a and 35c is closed, electrolyzed sulfuric acid or sulfuric acid supplied from the supply tank 10 through the supply pipe 106 and the channel 35a is returned to the circulating state where electrolyzed sulfuric acid or sulfuric acid is returned to the supply tank 10 through the channel 35b and the return pipe 108.

In the aforementioned discharging state, once the valve 200A is opened and the given water from the mixing pipe 200 is mixed with electrolyzed sulfuric acid, the temperature of the electrolyzed sulfuric acid rises by heat of reaction. Thus, when substrates are processed using electrolyzed sulfuric acid, the electrolyzed sulfuric acid remaining at a relatively low temperature (e.g., 60°C or lower) without passing through the heaters 159 may be guided from the production tank to the supply tank, and further to the discharge nozzles 106B. Then, the temperature of the electrolyzed sulfuric acid may be increased by the given water to a processing temperature (e.g., 120°C). Here, the recovering tank 30 need not recover the electrolyzed sulfuric acid through the recovering pipe 302 and the recovering pipe 304.

Once in the aforementioned discharging state, the valve 200A is opened and the given water from the mixing pipe 200 is mixed with sulfuric acid, a mixed solution (SPM) of sulfuric acid and aqueous hydrogen peroxide is generated.

### [Operations of substrate processing apparatus]

Next, operations of the substrate processing apparatus will be described. A substrate processing method to be performed by the substrate processing apparatus according to this embodiment includes the steps of: discharging electrolyzed sulfuric acid or sulfuric acid to the substrate W transported to the processing unit 600 to process the substrate W; cleaning the processed substrate W; rotating and drying the cleaned substrate W; and transporting the dried substrate W out of the processing unit 600.

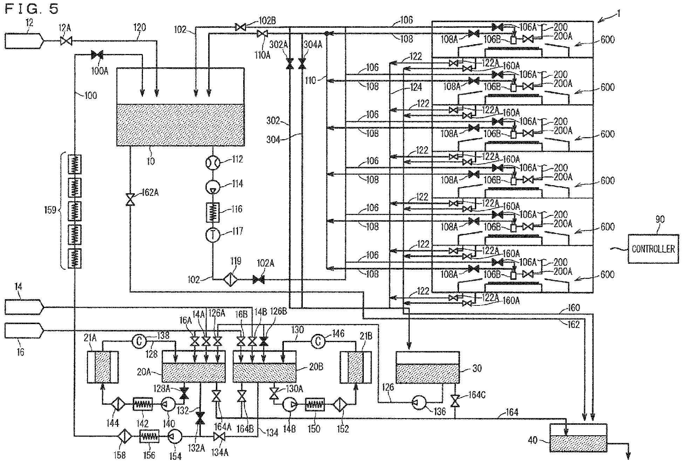

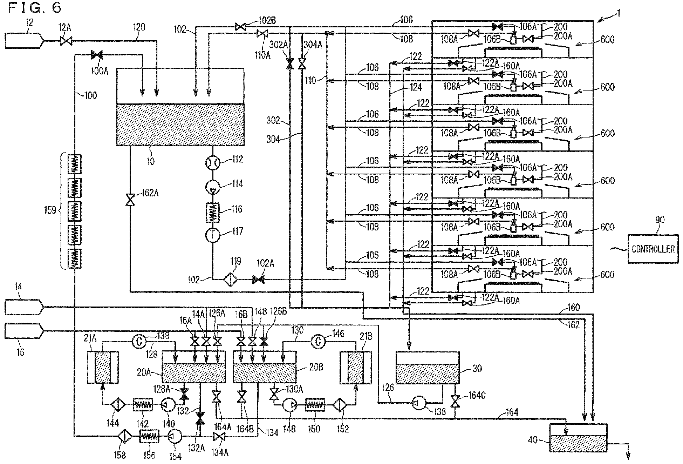

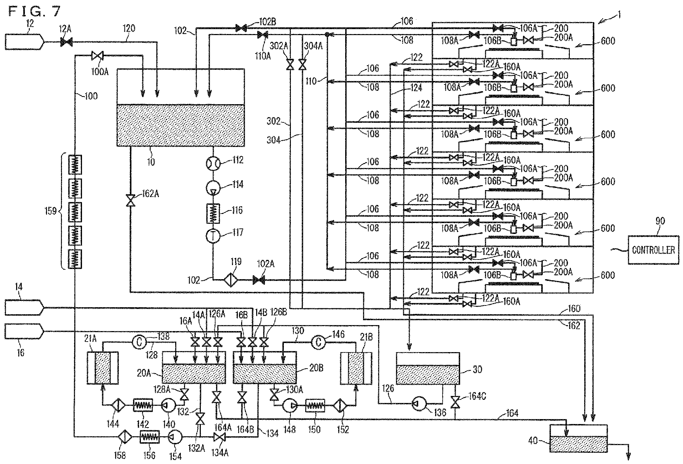

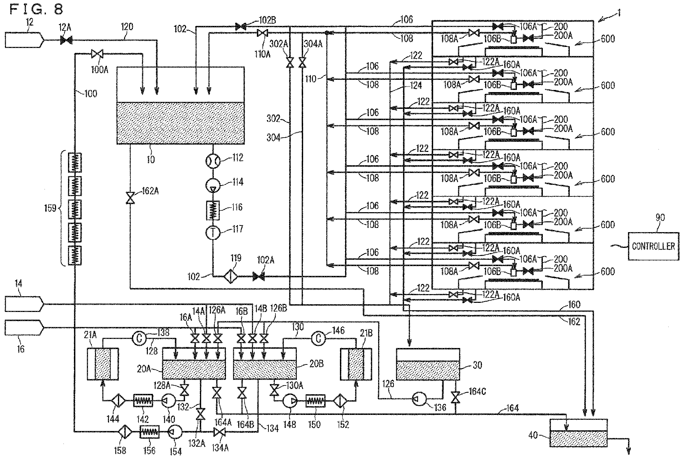

Hereinafter, the processes on the substrate which are included in the operations of the substrate processing apparatus will be described with reference to FIGS. 5, 6, 7, and 8. Here, FIG. 5 is a diagram illustrating an example structure of the substrate processing apparatus in the circulating state of the discharge nozzles 106B when electrolyzed sulfuric acid is supplied from the supply tank 10. Furthermore, FIG. 6 is a diagram illustrating an example structure of the substrate processing apparatus in the discharging state of the discharge nozzles 106B when electrolyzed sulfuric acid is supplied from the supply tank 10. Furthermore, FIG. 7 is a diagram illustrating an example structure of the substrate processing apparatus in the circulating state of the discharge nozzles 106B when sulfuric acid is supplied from the supply tank 10. Furthermore, FIG. 8 is a diagram illustrating an example structure of the substrate processing apparatus in the discharging state of the discharge nozzles 106B when sulfuric acid is supplied from the supply tank 10. In FIGS. 5, 6, 7, and 8, the valves in an open state are colored black. The operations below will be performed by controlling operations of the respective constituents (pumps, heaters, valves, or spin motors, etc.,) in the substrate processing apparatus 1 by the controller 90.

First, a mode of selecting a processing liquid containing electrolyzed sulfuric acid as a liquid to be supplied from the supply tank 10 under control of the controller 90 (a case illustrated in FIGS. 5 and 6) will be described.

First, sulfuric acid (H₂SO₄) is circulated between the production tank 20A and the electrolytic cell 21A through the circulation pipe 128 to generate a processing liquid containing electrolyzed sulfuric acid.

Sulfuric acid is appropriately supplied from the sulfuric acid supply source 16 to the production tank 20A by controlling the valve 16A by the controller 90. Furthermore, for example, pure water (DIW) is appropriately supplied from the pure water supply source 14 by controlling the valve 14A by the controller 90. As will be described later, the processed solution is supplied from the recovering tank 30 to the production tank 20A by controlling the valve 126A by the controller 90.

The temperature of the electrolyzed sulfuric acid stored in the production tank 20A is adjusted to, for example, 60°C or lower by the heater 142 in the circulation pipe 128 with the valve 128A being opened. Then, the filter 144 appropriately removes, for example, particles in the electrolyzed sulfuric acid, and the pump 140 feeds the electrolyzed sulfuric acid to the electrolytic cell 21A. Adjusting the temperature of the electrolyzed sulfuric acid to 60°C or lower (an electrolysis temperature) increases a generation rate of electrolyzed sulfuric acid when sulfuric acid is electrolyzed. Furthermore, adjusting the temperature of the electrolyzed sulfuric acid to 60°C or lower suppresses self-decomposition of the electrolyzed sulfuric acid into Caro's acid (H₂SO₅) and OH radicals.

Then, electrolyzing the sulfuric acid whose temperature has been adjusted by the electrolytic cell 21A generates a processing liquid containing the electrolyzed sulfuric acid. When sulfuric acid is electrolyzed, water molecules in the processing liquid are also electrolyzed. As sulfuric acid is electrolyzed more significantly, a concentration of the electrolyzed sulfuric acid becomes higher. The concentration meter 138 measures the concentration of the processing liquid containing the electrolyzed sulfuric acid. The controller 90 controls a flow rate of the electrolyzed sulfuric acid to be fed to the electrolytic cell 21A, based on the measured concentration (i.e., controlling the opening and closing of the valve 128A increases the flow rate of the electrolyzed sulfuric acid when the measured concentration is low, and reduces the flow rate of the electrolyzed sulfuric acid when the measured concentration is high). Reducing the concentration of the electrolyzed sulfuric acid increases the efficiency of generating persulfuric acid.

The production tank 20A forms a redundancy scheme with the production tank 20B. Thus, sulfuric acid (H₂SO₄) is circulated between the production tank 20B and the electrolytic cell 21B through the circulation pipe 130 to generate a processing liquid containing electrolyzed sulfuric acid, similarly to the production tank 20A.

Sulfuric acid is appropriately supplied from the sulfuric acid supply source 16 to the production tank 20B by controlling the valve 16B by the controller 90. Furthermore, for example, pure water (DIW) is appropriately supplied from the pure water supply source 14 by controlling the valve 14B by the controller 90. As will be described later, a processed solution is supplied from the recovering tank 30 to the production tank 20B by controlling the valve 126B by the controller 90.

The temperature of the electrolyzed sulfuric acid stored in the production tank 20B is adjusted to the electrolysis temperature (e.g., 60°C or lower) by the heater 150 in the circulation pipe 130 with the valve 130A being opened. Then, the filter 152 appropriately removes, for example, particles in the electrolyzed sulfuric acid, and the pump 148 feeds the electrolyzed sulfuric acid to the electrolytic cell 21B.

Then, electrolyzing the sulfuric acid whose temperature has been adjusted by the electrolytic cell 21B generates the processing liquid containing the electrolyzed sulfuric acid. The concentration meter 146 measures the concentration of the processing liquid containing the electrolyzed sulfuric acid. The controller 90 controls a flow rate of the electrolyzed sulfuric acid to be fed to the electrolytic cell 21B, based on the measured concentration by controlling the opening and closing of the valve 130A.

The production tank 20A and the production tank 20B can switchably supply the electrolyzed sulfuric acid to the supply tank 10. As exemplified in FIGS. 5 and 6, while the circulation pipe 128 circulates the electrolyzed sulfuric acid by opening the valve 128A, the production tank 20A supplies the electrolyzed sulfuric acid to the supply tank 10 by opening the valve 132A. During this time, the processed solution from the recovering tank 30 can be stored in the production tank 20B by closing the valves 130A and 134A. Alternatively, in the case where the concentration of the electrolyzed sulfuric acid stored in the production tank 20A does not reach a desired concentration, while the circulation pipe 128 continues to circulate the processing liquid by opening the valve 128A and closing the valve 132A to increase the concentration of the processing liquid by electrolyzing the sulfuric acid, the production tank 20B can supply the supply tank 10 with the electrolyzed sulfuric acid that circulates through the circulation pipe 130 and reaches the desired concentration. In other words, even when one of the production tanks (an electrolytic cell) is generating electrolyzed sulfuric acid, the other production tank can continuously supply electrolyzed sulfuric acid.

The temperature of the electrolyzed sulfuric acid supplied from one of (or both of) the production tanks is adjusted to, for example, 60°C or lower by the heater 156 in the supply pipe 100. Then, the filter 158 appropriately removes, for example, particles in the electrolyzed sulfuric acid, and the pump 154 feeds the electrolyzed sulfuric acid to the supply tank 10 through the valve 100A being opened.

The supply tank 10 stores the electrolyzed sulfuric acid supplied from the production tanks through the supply pipe 100. Here, the heaters 159 disposed in the supply pipe 100 that is upstream of the supply tank 10 increase, to, for example, 120°C, the temperature of the electrolyzed sulfuric acid whose temperature has been controlled to 60°C or lower until then.

The heater 116 adjusts, to a processing temperature (e.g., 120°C), the temperature of the electrolyzed sulfuric acid fed from the supply tank 10 through the circulation pipe 102 which is measured by the thermometer 117 in the circulation pipe 102. Then, the filter 119 appropriately removes, for example, particles in the electrolyzed sulfuric acid, and the pump 114 feeds the electrolyzed sulfuric acid to the processing units 600 and the production tanks. The controller 90 understands the processes on substrates to be performed by the processing units 600 with reference to the processing recipe, and adjusts a flow rate of the electrolyzed sulfuric acid circulating through the circulation pipe 102 by, for example, opening and closing the valve 102A such that the flow rate of the electrolyzed sulfuric acid which is measured by the flowmeter 112 becomes sufficient for processing the substrates.

The supply pipes 106 branching into the respective processing units 600 are disposed downstream of the circulation pipe 102. Then, opening a corresponding one of the valves 106A under control of the controller 90 can appropriately supply the electrolyzed sulfuric acid to the processing unit 600.

While the discharge nozzles 106B are in the circulating state (the valve body 37 is in contact with the seating surface 46 in FIG. 4), the valves 106A and 108A are opened. The electrolyzed sulfuric acid supplied from the circulation pipe 102 to the supply pipes 106 and further to the return pipes 108 merges into the circulation pipe 110, and is recovered by the recovering tank 30 through the recovering pipe 304. Furthermore, the electrolyzed sulfuric acid supplied from the circulation pipe 102 to the recovering pipe 302 is recovered by the recovering tank 30. As such, when electrolyzed sulfuric acid is discharged to process substrates, circulation of the electrolyzed sulfuric acid that flows into the discharge nozzles 106B in the supply pipes 106 can inhibit a temperature change in electrolyzed sulfuric acid which is caused by a temperature difference between a pipe and the electrolyzed sulfuric acid. The flow rate of the electrolyzed sulfuric acid supplied through the return pipes 108 in the circulating state is desirably suppressed to the minimum to maintain the temperature of the pipe.

In the discharging state of the discharge nozzles 106B (the valve body 37 is separated from the seating surface 46 in FIG. 4), the valves 108A are closed while the valves 106A are opened. The electrolyzed sulfuric acid is discharged from the outlet 31 of each of the discharge nozzles 106B toward the upper surface of the substrate W. Then, the substrates are processed.

Here, immediately before the electrolyzed sulfuric acid is discharged from the outlet 31, the mixing pipe 200 with the valve 200A being opened may mix the given water with the electrolyzed sulfuric acid in the channel 35c. When the given water such as pure water is mixed with the processing liquid containing electrolyzed sulfuric acid, heat of reaction further increases the temperature of the processing liquid and increases the oxidizing strength.

The electrolyzed sulfuric acid discharged to the substrate W and used for processing the substrate flows, as a processed solution, into the drainage pipe 122 through the valve 122A being opened. The processed solution contains sulfate ion (SO₄²⁻). Then, the processed solution merges into the recovering pipe 124, and is recovered by the recovering tank 30.

The electrolyzed sulfuric acid can be used again for processing substrates by being recovered and electrolyzed again. Thus, processing the substrate using the processing liquid containing the electrolyzed sulfuric acid can reduce drainage caused by processing the substrate.

The pump 136 can selectively feed, through the recovering pipe 126, the processed solution stored in the recovering tank 30 to (i.e., one of or both of) the production tank 20A by opening the valve 126A and the production tank 20B by opening the valve 126B.

Next, a mode of selecting sulfuric acid as a liquid to be supplied from the supply tank 10 under control of the controller 90 (a case illustrated in FIGS. 7 and 8) will be described.

First, the supply tank 10 stores the sulfuric acid supplied from the sulfuric acid supply source 12 through the supply pipe 120.

The heater 116 adjusts the temperature of the sulfuric acid fed from the supply tank 10 through the circulation pipe 102 such that the temperature measured by the thermometer 117 in the circulation pipe 102 becomes a desired temperature. Then, the filter 119 appropriately removes, for example, particles in the sulfuric acid, and the pump 114 feeds the sulfuric acid to the processing units 600. The controller 90 understands the processes on substrates to be performed by the processing units 600 with reference to the processing recipe, and adjusts a flow rate of the sulfuric acid circulating through the circulation pipe 102 by, for example, opening and closing the valve 102A such that the flow rate of the sulfuric acid measured by the flowmeter 112 becomes sufficient for processing the substrates.

The supply pipes 106 branching into the respective processing units 600 are disposed downstream of the circulation pipe 102. Then, opening a corresponding one of the valves 106A under control of the controller 90 can appropriately supply the sulfuric acid to the processing unit 600.

While the discharge nozzles 106B are in the circulating state (the valve body 37 is in contact with the seating surface 46 in FIG. 4), the valves 106A and 108A are opened. The sulfuric acid supplied from the circulation pipe 102 to the supply pipes 106 and further to the return pipes 108 merges into the circulation pipe 110, and is returned to the supply tank 10. Furthermore, the sulfuric acid that is not diverted from the circulation pipe 102 to the supply pipes 106 is returned to the supply tank 10 as it is. As such, when sulfuric acid is discharged to process substrates, circulation of the sulfuric acid that flows into the discharge nozzles 106B in the supply pipes 106 can inhibit a temperature change in sulfuric acid which is caused by a temperature difference between a pipe and the sulfuric acid. The flow rate of the sulfuric acid supplied through the return pipes 108 in the circulating state is desirably suppressed to the minimum to maintain the temperature of the pipe.

In the discharging state of the discharge nozzles 106B (the valve body 37 is separated from the seating surface 46 in FIG. 4), the valves 108A are closed while the valves 106A are opened. The sulfuric acid is discharged from the outlet 31 of each of the discharge nozzles 106B toward the upper surface of the substrate W. Then, the substrates are processed.

Here, immediately before the sulfuric acid is discharged from the outlet 31, the mixing pipe 200 with the valve 200A being opened mixes the given water with the sulfuric acid in the channel 35c. Once the given water such as aqueous hydrogen peroxide is mixed with sulfuric acid, a mixed solution (SPM) of sulfuric acid and aqueous hydrogen peroxide is generated.

The sulfuric acid discharged to the substrate W and used for processing the substrate flows into the drainage pipe 160 through the valve 160A being opened. Then, the sulfuric acid is recovered by the waste tank 40.

Here, even when sulfuric acid is selected as a liquid to be supplied from the supply tank 10, circulation of electrolyzed sulfuric acid between the production tank and the electrolytic cell may be continued so that the electrolyzed sulfuric acid can be smoothly supplied in the next switching time.

As described above, switching between valve opening/closing patterns in FIGS. 5, 6, 7, and 8 by the controller 90 can switch between electrolyzed sulfuric acid and sulfuric acid, and can further easily switch between the circulating state and the discharging state. The supply tank 10 stores both of electrolyzed sulfuric acid and sulfuric acid. After discharging a processing liquid used in a previous mode from the supply tank 10 is completed, a processing liquid to be used in the subsequent mode should be stored in the supply tank 10.

Thus, a single device can continuously perform various types of processes on substrates. For example, a plurality of processes on substrates using electrolyzed sulfuric acid and sulfuric acid which are predefined for substrates to be transported can be continuously performed on a substrate fixed to one of the processing units 600.

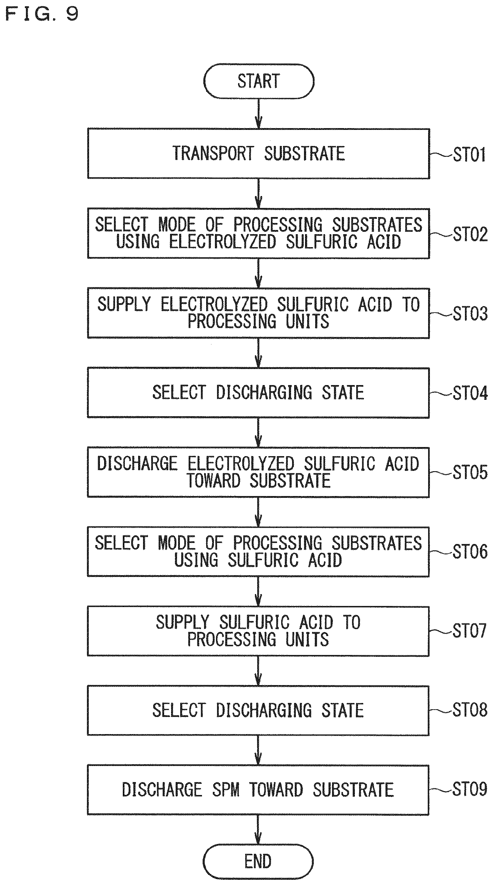

FIG. 9 is a flowchart when the substrate processing apparatus according to this embodiment continuously performs the plurality of processes on substrates.

As exemplified in FIG. 9, first, the substrate W is transported into the processing unit 600 (Step ST01).

Next, a mode of processing substrates using electrolyzed sulfuric acid (the circulating state) is selected by the controller 90 to open the relevant valve 100A, valve 102A, valves 106A, valves 108A, valve 302A, valve 304A, valve 126B, valve 128A, and valve 132A as illustrated in FIG. 5 (Step ST02). The processes on substrates using electrolyzed sulfuric acid include, for example, removing a resist film formed on the upper surface of the substrate W.

Next, the production tank 20A supplies the electrolyzed sulfuric acid to the supply tank 10. Then, the supply tank 10 supplies the electrolyzed sulfuric acid to the respective processing units 600 (Step ST03). In this phase, the valve body 37 is in contact with the seating surface 46 in FIG. 4. The electrolyzed sulfuric acid is circulated through the recovering pipe 302 branching from the circulation pipe 102 or through the return pipes 108 downstream of the supply pipes 106, without discharging the electrolyzed sulfuric acid from the discharge nozzles 106B, and is recovered by the recovering tank 30.

Furthermore, while generating the electrolyzed sulfuric acid, the production tank and the electrolytic cell supply the electrolyzed sulfuric acid to the supply tank 10.

Next, a mode of processing substrates using electrolyzed sulfuric acid (the discharging state) is selected by the controller 90 to close the valves 108A and the valve 304A and open the valves 122A as illustrated in FIG. 6 (Step ST04).

Then, the discharge nozzle 106B discharges the electrolyzed sulfuric acid toward the upper surface of the substrate W (Step ST05). Here, the valve body 37 is separated from the seating surface 46 in FIG. 4.

Next, while the arrangement of the substrates W in the processing units 600 remains the same, other processes are performed on the substrates. Specifically, the substrates are processed using sulfuric acid.

Specifically, a mode of processing substrates using sulfuric acid (the circulating state) is selected by the controller 90 to close the valve 100A, the valves 122A, the valve 126B, the valve 128A, the valve 132A, and the valve 302A and to open the valve 12A, the valve 102B, the valves 108A, and the valve 110A as illustrated in FIG. 7 (Step ST06). The processes on substrates using sulfuric acid (SPM) include, for example, removing a metal film formed on the substrate W which requires controlling an etching rate with high accuracy.

Next, the sulfuric acid supply source 12 supplies sulfuric acid to the supply tank 10. Then, the supply tank 10 supplies the sulfuric acid to the respective processing units 600 (Step ST07). In this phase, the valve body 37 is in contact with the seating surface 46 in FIG. 4. The sulfuric acid is circulated in the supply tank 10 through the circulation pipe 102 or through the return pipes 108 downstream of the supply pipes 106, without discharging the sulfuric acid from the discharge nozzles 106B.

Next, a mode of processing substrates using sulfuric acid (the discharging state) is selected by the controller 90 to close the valves 108A and the valve 110A and open the valves 160A and the valves 200A as illustrated in FIG. 8 (Step ST08).

Then, the discharge nozzle 106B mixes the sulfuric acid and the given water supplied through the mixing pipe 200, and discharges the generated SPM to the upper surface of the substrate W (Step ST09). Here, the valve body 37 is separated from the seating surface 46 in FIG. 4.

Here, to increase the oxidizing strength of the processes on substrates using electrolyzed sulfuric acid, the discharge nozzle 106B may mix the electrolyzed sulfuric acid and the given water supplied through the mixing pipe 200 to increase the temperature of the electrolyzed sulfuric acid. Using such electrolyzed sulfuric acid at a high temperature can remove a high-dose implanted resist film.

### <Advantages produced by embodiment above>

Next, advantages produced by the embodiment above will be described. While the advantages are described based on the specific structures whose examples are described in the embodiment above, the structures may be replaced with other specific structures whose examples are described in this DESCRIPTION as long as the same advantages are produced. In other words, while only one of the associated specific structures is sometimes described as a representative for convenience, the structure may be replaced with another specific structure associated with the specific structure described as a representative.

According to the embodiment above, a substrate processing apparatus includes a substrate processing part, the supply tank 10, a generator, a recovering part, a supply source, a circulation part, and a valve mechanism. Here, the substrate processing part corresponds to, for example, the processing unit 600 including the discharge nozzle 106B. Furthermore, the generator corresponds to, for example, the production tank 20A (or the production tank 20B) connected to an electrolytic cell. Furthermore, the recovering part corresponds to, for example, the recovering pipe 302, the recovering pipe 304, or the recovering pipe 124 to be connected to the recovering tank 30. Furthermore, the supply source corresponds to, for example, the sulfuric acid supply source 12. Furthermore, the circulation part corresponds to, for example, the circulation pipe 102 or the circulation pipe 110. The valve mechanism is, for example, a valve group whose opened and closed states are changed in switching between the mode of processing substrates using electrolyzed sulfuric acid and the mode of processing substrates using sulfuric acid or in switching between the circulating state and the discharging state, and corresponds to, for example, the valve 12A, the valve 100A, the valve 102B, the valves 108A, the valve 110A, the valves 122A, the valve 302A, and the valve 304A. The substrate processing part processes the substrate W using a first processing liquid containing electrolyzed sulfuric acid or a second processing liquid containing sulfuric acid. The supply tank 10 supplies the first processing liquid or the second processing liquid to the substrate processing part. The generator generates the first processing liquid through electrolysis to supply the generated first processing liquid to the supply tank 10. The recovering part recovers the first processing liquid supplied to the substrate processing part to supply the first processing liquid to the generator. The sulfuric acid supply source 12 supplies the second processing liquid to the supply tank 10. The circulation part circulates, through the supply tank 10, the second processing liquid supplied to the substrate processing part. The valve mechanism is switchable between a first mode that is a mode in which the substrate processing part processes the substrate W using the first processing liquid and a second mode that is a mode in which the substrate processing part processes the substrate W using the second processing liquid. Here, the valve mechanism includes a first valve (e.g., the valve 100A), a second valve (e.g., the valve 304A or the valve 122A), a third valve (e.g., the valve 12A), and a fourth valve (e.g., the valve 102B or the valve 110A). The first valve is disposed in a first pipe (e.g., the supply pipe 100) for supplying the supply tank 10 with the first processing liquid generated by the generator. The second valve is disposed in a second pipe (e.g., the recovering pipe 304, the drainage pipe 122, or the recovering pipe 124) to allow the generator to recover, from the substrate processing part, the first processing liquid supplied to the substrate processing part. The third valve is disposed in a third pipe (e.g., the supply pipe 120) for supplying the supply tank 10 with the second processing liquid from the sulfuric acid supply source 12. The fourth valve is disposed in a fourth pipe (e.g., the circulation pipe 102 or the circulation pipe 110) for circulating the second processing liquid through the supply tank 10. In the first mode, the first valve and the second valve are opened, and the third valve and the fourth valve are closed. In the second mode, the third valve and the fourth valve are opened, and the first valve and the second valve are closed.

In such a structure, switchably using electrolyzed sulfuric acid and sulfuric acid for processing the substrate W can select an appropriate processing liquid for various processes on substrates and efficiently process the substrates.

When the other structures whose examples are described in the DESCRIPTION are appropriately added to the structure above, that is, the other structures in the DESCRIPTION which are not mentioned as the structure above are appropriately added, the same advantages can be produced.

According to the embodiment above, the substrate processing part includes a mixing part that mixes given water with the first or second processing liquid supplied from the supply tank 10. Here, the mixing part corresponds to, for example, the mixing pipe 200. In such a structure, when the given water is mixed with sulfuric acid, SPM can be generated. When the given water is mixed with electrolyzed sulfuric acid, heat of reaction increases the temperature of the electrolyzed sulfuric acid and increases the oxidizing strength.

According to the embodiment above, the substrate processing apparatus includes, in the supply pipe 100, the heaters 159 for increasing the temperature of the first processing liquid to the temperature for processing the substrate W. Such a structure can supply electrolyzed sulfuric acid to the processing units 600 while increasing the temperature of the electrolyzed sulfuric acid to the processing temperature.

According to the embodiment above, a substrate processing method includes: a first step of supplying the substrate processing part with the first processing liquid for processing the substrate W; and a second step of supplying the substrate processing part with the second processing liquid for processing the substrate W. Here, the first step includes supplying the supply tank 10 with the first processing liquid generated by the generator, and allowing the generator to recover, through the recovering part, the first processing liquid supplied from the supply tank 10 to the substrate processing part. Furthermore, the second step includes supplying the second processing liquid from the sulfuric acid supply source 12 to the supply tank 10, and circulating, in the supply tank 10 through the circulation part, the second processing liquid supplied from the supply tank 10 to the substrate processing part.

In such a structure, switchably using electrolyzed sulfuric acid and sulfuric acid for processing the substrate W can select an appropriate processing liquid for various processes on substrates and efficiently process the substrates.

When there is no particular limitation, the order of the processes can be changed.

When the other structures whose examples are described in the DESCRIPTION are appropriately added, that is, the other structures in the DESCRIPTION which are not mentioned as the structure above are appropriately added to the structure above, the same advantages can be produced.

### <Modifications of embodiment above>

Although the embodiment above may specify materials, dimensions, shapes, relative arrangement relationships, and conditions for implementation of each of the constituent elements, these are in all aspects examples and do not restrict the invention.

Therefore, numerous modifications and equivalents that have not yet been exemplified will be devised within the scope of the technology disclosed in the DESCRIPTION. Examples of the modifications include modifying, adding, or omitting at least one constituent element.

When at least one embodiment above specifies, for example, the name of a material without any particular designation, the material includes another additive, for example, an alloy unless it is contradictory.

### EXPLANATION OF REFERENCE SIGNS

1 substrate processing apparatus
10 supply tank
12A valve
14A valve
14B valve
16A valve
16B valve
100A valve
102A valve
102B valve
106A valve
108A valve
110A valve
116 heater
122A valve
126A valve
126B valve
128A valve
130A valve
132A valve
134A valve
142 heater
150 heater
156 heater
159 heater
160A valve
162A valve
164A valve
164B valve
164C valve
200A valve
302A valve
304A valve
W substrate

## Claims

1. A substrate processing apparatus, comprising:
a substrate processing part for processing a substrate using a first processing liquid containing electrolyzed sulfuric acid or a second processing liquid containing sulfuric acid;
a supply tank for supplying the first or second processing liquid to the substrate processing part;
a generator that generates the first processing liquid through electrolysis such that the generated first processing liquid can be supplied to the supply tank;
a recovering part that recovers the first processing liquid supplied to the substrate processing part to supply the first processing liquid to the generator;
a supply source that can supply the second processing liquid to the supply tank;
a circulation part for circulating, through the supply tank, the second processing liquid supplied to the substrate processing part; and
a valve mechanism that is switchable between a first mode and a second mode, the first mode being a mode in which the substrate processing part processes the substrate using the first processing liquid, the second mode being a mode in which the substrate processing part processes the substrate using the second processing liquid, the valve mechanism including:
a first valve disposed in a first pipe for supplying the supply tank with the first processing liquid generated by the generator;
a second valve disposed in a second pipe to allow the generator to recover, from the substrate processing part, the first processing liquid supplied to the substrate processing part;
a third valve disposed in a third pipe for supplying the supply tank with the second processing liquid from the supply source; and
a fourth valve disposed in a fourth pipe for circulating the second processing liquid through the supply tank,
wherein in the first mode, the first valve and the second valve are opened, and the third valve and the fourth valve are closed, and
in the second mode, the third valve and the fourth valve are opened, and the first valve and the second valve are closed.

2. The substrate processing apparatus according to claim 1,
wherein the substrate processing part further includes a mixing part for mixing given water with the first or second processing liquid supplied from the supply tank.

3. The substrate processing apparatus according to claim 1 or 2, further comprising
a heater in the first pipe for increasing a temperature of the first processing liquid to a temperature for processing the substrate.

4. A substrate processing method for processing a substrate using a substrate processing apparatus including:
a substrate processing part for processing the substrate using a first processing liquid containing electrolyzed sulfuric acid or a second processing liquid containing sulfuric acid;
a supply tank for supplying the first or second processing liquid to the substrate processing part;
a generator that generates the first processing liquid through electrolysis such that the generated first processing liquid can be supplied to the supply tank;
a recovering part that recovers the first processing liquid supplied to the substrate processing part to supply the first processing liquid to the generator;
a supply source that can supply the second processing liquid to the supply tank; and
a circulation part for circulating, through the supply tank, the second processing liquid supplied to the substrate processing part, the method comprising:
a first step of supplying the substrate processing part with the first processing liquid for processing the substrate; and
a second step of supplying the substrate processing part with the second processing liquid for processing the substrate,
wherein the first step includes supplying the supply tank with the first processing liquid generated by the generator, and allowing the generator to recover, through the recovering part, the first processing liquid supplied from the supply tank to the substrate processing part, and
the second step includes supplying the second processing liquid from the supply source to the supply tank, and circulating, in the supply tank through the circulation part, the second processing liquid supplied from the supply tank to the substrate processing part.
